Europäisches Patentamt

European Patent Office

Office européen des brevets

(19)

(11) Publication number: **0 343 278 B1**

(12) **EUROPEAN PATENT SPECIFICATION**

(45) Date of publication of patent specification: **20.04.94**  (51) Int. Cl.5: **H03H 17/02**

(21) Application number: **88108525.2**

(22) Date of filing: **27.05.88**

(54) **Digital filter.**

(43) Date of publication of application:
**29.11.89 Bulletin 89/48**

(45) Publication of the grant of the patent:
**20.04.94 Bulletin 94/16**

(84) Designated Contracting States:
**AT BE CH DE FR GB IT LI LU NL SE**

(56) References cited:

**INTERNATIONAL JOURNAL OF CIRCUIT THE-ORY AND APPLICATIONS, vol. 1, 1973, pages 323-337, John Wiley & Sons, Ltd, Chichester, GB; A. FETTWEIS: "Reciprocity, inter-reciprocity, and transposition in wave digital filters"**

**Reference 9 of the description (see p. 28, l. 28 and p.29, l.1) by the inventor, A. Fettweis.**

(73) Proprietor: **SIEMENS AKTIENGESELLSCHAFT**
**Wittelsbacherplatz 2**
**D-80333 München(DE)**

(72) Inventor: **Fettweis, Alfred, Prof. Dr.**
**Im Königsbusch 30**
**D-4630 Bochum(DE)**

Rank Xerox (UK) Business Services
(3.10/3.09/3.3.3)

EP 0 343 278 B1

## Description

### 1. Introduction

Wave digital filters (WDFs) /1/ are known to have many interesting properties /2/. The most important of these concern their excellent stability behavior, in particular with respect to all aspects resulting from the nonlinarities that are caused by the signal quantizing operations required for carrying out rounding/truncation and overflow correction, and their good dynamic range performance. Other advantageous properties hold more specifically for voltage-wave digital filters (VWDFs), i.e., the type of WDFs usually considered and with which the present paper is also concerned: the small number of multipliers required, at least if the most appropriate structures are selected, and the small number of nonzero bits needed for implementing the multiplier coefficients.

On the other hand, VWDFs require more adders than multipliers, at least if the most common type of implementation is adopted, i.e., the one that is the most economical in number of multipliers. This is not a disadvantage if a dedicated hardware is used, but can be undesirable if the implementation should be done by means of general-purpose digital signal processors of the types hitherto available. For these digital signal processors an individual computing cycle consists indeed always of one multiplication combined with an accumulation (addition). Hence, an individual addition requires a full cycle, i.e., a multiplication by 1 followed by the addition itself. This can be a disadvantage for the implementation of WDFs, especially in the case of floating-point arithmetic. Recall that in a WDF the arithmetic operators (adders and multipliers) are grouped in so-called adaptors.

The purpose of the present invention, as defined in Claim 1 is to show how the disadvantage just mentioned can be overcome in a wide class of WDFs, i.e., those for which only two-port adaptors are needed, by reducing appreciably the number of cycles needed for carrying out the computations. This class includes the most attractive realization of lattice WDFs, i.e. those types of WDFs that have proved so far to be the most attractive ones in practice. It will be seen that the realizations thus obtained are such that they can make use to great advantage of a feature available in several digital signal processors (see e.g. /3/). This feature allows one indeed to ensure that if an overflow occurs after a multiply-add operation the result is directly obtained according to a saturation characteristic. Due to the specific properties of WDFs this guarantees not only suppression of overflow oscillations, but also forced-response stability and related properties /2,4-8/.

Although we have so far stressed two-port adaptors, the method is also applicable in the case of adaptors with more than two ports. Considerable advantages are then still obtainable, but the reduction in number of cycles decreases with the number of ports of the adaptor. Note however that more than three ports are rarely needed in practice.

The crux of the method consists in inserting, at selected locations of the original structure, appropriately chosen pairs of inverse multipliers and then to combine each such multiplier with the adaptor to which it is adjacent. The pairs of inverse multipliers do not necessarily correspond to ideal transformers. Hence, we may no longer simply speak of port resistances or conductances (weights), but the two terminals of a same terminal-pair in the final structure may very well have different weights. This answers in a positive way a question that had been left open in a recent paper on fully general passive and lossless digital filter structures /9/. It had indeed been mentioned there that it was "not known whether there exist situations in which further simplifications could result" by choosing distinct weights for the two terminals of a same terminal-pair.

If not otherwise mentioned, terminology and notation will be as given in /2/. -

Further objects, features and other aspects of the present invention will be understood from the following detailed description of preferred embodiments of the present invention referring to the accompanying drawings.

Fig. 1a      is the diagram of a 1st-degree all-pass section of the prior art

Fig. 1b      is the diagram of a filter section according to the present invention derived from Fig. 1a by inserting pairs of inverse multipliers at appropriate locations

Fig. 1c      is a simplified representation of Fig. 1b

Fig. 2a      is a second-degree all-pass section of the prior art

Fig. 2b      is the diagram of a filter section according to the present invention derived from Fig.2a by inserting pairs of inverse multipliers at appropriate locations

Fig. 2c      is a simplified representation of Fig. 2b

Fig. 3a      is the diagram of an all-pass structure of degree n of the prior art

Fig. 3b      is the diagram of an all-pass structure according to the present invention derived from Fig.3a by inserting, at appropriate locations, pairs of inverse multipliers and combining them (except for the two multipliers at the left) with the adaptor to which they are closest.

Fig. 4a is a diagram of a structure of a lattice wave digital filter of the prior art with one input and one output terminal

Fig. 4b is a diagram of a structure of a lattice wave digital filter obtained by realizing all-pass functions according to the present invention

Fig. 4c,4d are diagrams of equivalent structures of the lattice wave digital filter according to the present invention derived from Fig. 4b.

Fig. 5a is the diagram of a filter structure of a two-port lattice wave digital filter of the prior art

Fig. 5b is the diagram of a filter structure of a two-port lattice wave digital filter derived from Fig. 5a by realizing all-pass functions according to the present invention

Fig. 6a is the diagram of a filter reference filter of the prior art in form of a cascade of unit elements

Fig. 6b is the diagram of a filter structure of a wave digital filter obtained from a reference filter of Fig. 6a

Fig. 6c is the diagram of a filter structure of a wave digital filter of the present invention derived from Fig. 6b by inserting, at appropriate locations, pairs of inverse multipliers (including multipliers for port 0) and combining them with the adaptor to which they are closest.

## 2. Reactances and all-pass structures involving two-port adaptors

### 2.1 First-degree sections

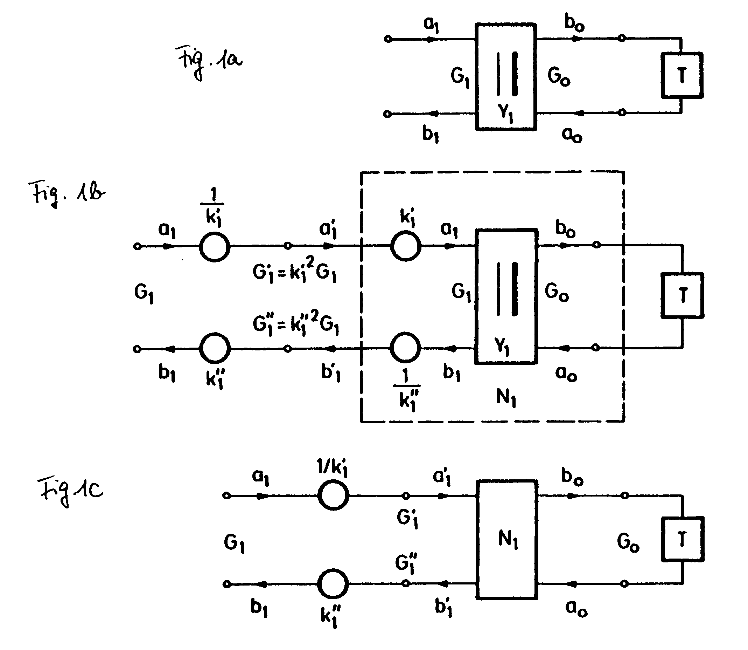

Since WDFs are based on using wave quantities rather than voltages and currents, realizing an impedance or admittance is equivalent to realizing a reflectance; in particular realizing a reactance is equivalent to realizing an all-pass structure. A first-degree all-pass section is shown in Fig. 1a. Contrary to what we have previously usually done /2/, we have indicated port conductances (weights) rather than port resistances, and we will do the same in corresponding later figures in this paper, such conductances (weights) being of course positive quantities. Consequently, for the multiplier coefficient $\gamma_1$ we have

$$\gamma_1 = (G_1-G_o)/(G_o+G_1) , \qquad |\gamma_1| < 1 , \qquad (1a,b)$$

and the equations describing the two-port adaptor are

$$b_o = -\gamma_1 a_o + (1+\gamma_1)a_1 , \qquad (2a)$$

$$b_1 = (1-\gamma_1)a_o + \gamma_1 a_1 , \qquad (2b)$$

the subscript 1 being given to $\gamma$ for reasons that will become clear later. We may assume $\gamma \neq 0$ since otherwise the equations (2) become trivial and a problem of simplifying them does not arise.

We now insert pairs of inverse multipliers with coefficients $k_1'$, $1/k_1'$, $k_1''$, and $1/k_1''$ as shown in Fig. 1b. Observe that the two multipliers of such a pair are placed directly in cascade. This does not change the signals $a_1$ and $b_1$ at the input port of the overall arrangement. We can combine the adaptor and its two adjacent multipliers into a new building block, $N_1$, as indicated by means of a broken line in Fig. 1b. This building block may be said to be frequency-independent just like an adaptor since it does not contain any delay. From Fig. 1b we derive

$$a_1 = k_1' a_1' , \qquad b_1 = k_1'' b_1' . \qquad (3a;b)$$

Hence, $N_1$ is described by

$$b_o = \gamma_{00}a_o + \gamma_{01}a_1' , \qquad (4a)$$

$$b_1' = \gamma_{10}a_o + \gamma_{11}a_1' \qquad (4b)$$

3

where

$$\gamma_{00} = -\gamma_1 \ , \qquad\qquad \gamma_{01} = (1+\gamma_1)k_1' \qquad\qquad (5a,b)$$

$$\gamma_{10} = (1-\gamma_1)/k_1'' \ , \quad \gamma_{11} = \gamma_1 k_1'/k_1'' \ . \qquad\qquad (5c,d)$$

We have two alternatives for making equal to unity one of the coefficients in each one of the equations (4a) and (4b). The first alternative is

$$k_1' = 1/(1+\gamma_1) \ , \quad k_1'' = 1-\gamma_1 \cdot \ k_1''/k_1' = 1-\gamma_1^2 \ , \qquad (6a,b,c)$$

which leads to

$$\gamma_{00} = -\gamma_1 \ , \quad \gamma_{01} = \gamma_{10} = 1 \ , \quad \gamma_{11} = \gamma_1/(1-\gamma_1^2) \ . \ (7)$$

The second alternative is

$$k_1' = 1/(1+\gamma_1) \ , \quad k_1'' = \gamma_1/(1+\gamma_1) \ , \ k_1''/k_1' = \gamma_1 \qquad (8a,b,c)$$

and leads to

$$\gamma_{00} = -\gamma_1 \ , \quad \gamma_{01} = \gamma_{11} = 1 \ , \quad \gamma_{10} = (1-\gamma_1^2)/\gamma_1 \ . \qquad (9)$$

Since $|\gamma_1| < 1$, we can always ensure, if desired, that none of the coefficients in (4) is larger than 1 in modulus. This possibility is offered by (6) and (7) for $|\gamma_1| \le (\sqrt{5}-1)/2 \approx 0{,}618$, and by (8) and (9) for $|\gamma_1| \ge (\sqrt{5}-1)/2$. In (6) and (8) we have supplemented the expressions for $k_1'$ and $k_1''$ simple expressions for $k_1''/k_1'$ ; these show that we always have

$$|k_1''/k_1'| \le 1 \ . \qquad\qquad (10)$$

There remain of course the two multipliers to the left of $N_1$ in Figs. 1b and 1c. These may obviously be combined into a single multiplier of coefficient $k_1''/k_1'$ . In some cases this single multiplier may even simply be dropped, but in others, this is not permitted. In any case, the implementation of $N_1$ requires only 2 multiply-accumulate steps. A simplified overall representation of the structure of Fig. 1b is shown in Fig. 1c.

In addition to the port conductances $G_o$ and $G_1$, the weights

$$G_1' = k_1'^2 G_1 \ , \quad G_1'' = k_1''^2 G_1 \ , \qquad\qquad (11a,b)$$

are indicated in Fig. 1b and 1c. Only $G_o$ corresponds to a true port conductance, while $G_1'$ and $G_1''$ are the individual terminal weights of the two terminals of $N_1$ at its access on the left. These two terminals thus do not form a true port. The role played by $G_1'$ and $G_1''$ will become clear in Section 3.

It is obvious from what we have said that $N_1$ may be no longer termed a two-port, although it is a four-terminal (building) block or, simpler, a 4-pole block.

## 2.2 Sections of degree two and higher

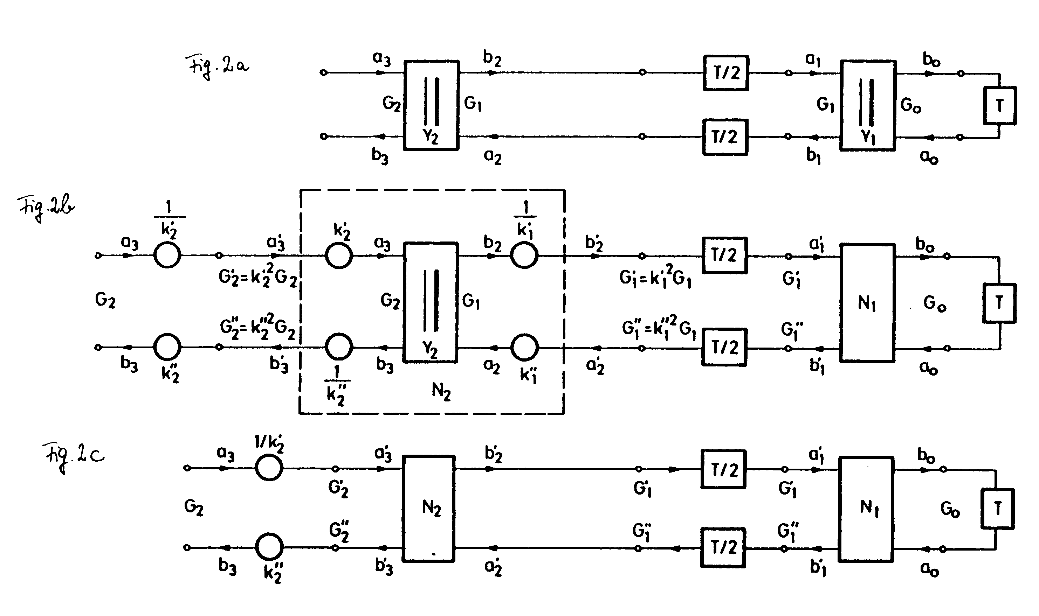

A situation in which the multipliers to the left of $N_1$ mentioned in Subsection 2.1 may not immediately be dropped is encountered in a second-degree all-pass section as shown in Fig. 2a. Note that we could there combine the two delays T/2 into a single delay T, but we have preferred keeping them separate for the sake of symmetry and for reasons as explained in /2/. We can again transform Fig. 2a in a way similar to what we have done previously, which leads to Fig. 2b. The port to the right in Fig. 2a is assumed to be transformed as in Fig. 1, with $N_1$ thus being as in Figs. 1b and 1c. The multipliers $l/k_1'$ and $k_1''$, however, have been shifted across the two delays T/2 and have been inserted into what is becoming $N_2$. In addition to the weights $G_1'$, and $G_1''$ given by (10) we now also have to consider terminal weights

$$G_2' = k_2'^2 G_2 \quad , \quad G_2'' = k_2''^2 G_2 \; . \qquad (12)$$

A simplified overall representation of the structure of Fig. 2b is shown in Fig. 2c.

The equations describing the left adaptor in Fig. 2a are

$$b_2 = -\gamma_2 a_2 + (1+\gamma_2)a_3 \; , \qquad (13a)$$

$$b_3 = (1-\gamma_2)a_2 + \gamma_2 a_3 \; , \qquad (13b)$$

where

$$\gamma_2 = (G_2 - G_1)/(G_2 + G_1) \; , \qquad |\gamma_2| < 1 \; , \qquad (14a,b)$$

(14b) following again from (14a) because $G_1 > 0$ and $G_2 > 0$. We may assume $\gamma_2 \neq 0$. Since (cf. Fig. 2b)

$$a_2 = k_1'' a_2' \; , \qquad b_2 = k_1' b_2' \; , \qquad (15a,b)$$

$$a_3 = k_2' a_3' \; . \qquad b_3 = k_2'' b_3' \; , \qquad (15c,d)$$

(13) gives rise to

$$b_2' = \gamma_{22} a_2' + \gamma_{23} a_3' \; , \qquad (16a)$$

$$b_3' = \gamma_{32} a_2' + \gamma_{33} a_3' \qquad (16b)$$

where

$$\gamma_{22} = -\gamma_2 k_1''/k_1' \; , \qquad \gamma_{23} = (1+\gamma_2)k_2'/k_1' \; , \qquad (17a,b)$$

$$\gamma_{32} = (1-\gamma_2)k_1''/k_2'' \; , \qquad \gamma_{33} = \gamma_2 k_2'/k_2'' \; . \qquad (17c,d)$$

These equations thus describe a new 4-pole block, $N_2$, indicated in Fig. 2b by means of a broken line and shown in compact form in Fig. 2c.

In (15), $k_2'$, and $k_2''$ may be chosen arbitrarily, but $\gamma_{22}$ cannot be influenced by the choice available. Like for $N_1$, we have thus two choices for making equal to unity one of the coefficients in each one of the equations (16a) and (16b), i.e., on the one hand,

5

$$k'_2 = k'_1/(1+\gamma_2) \quad , \quad k''_2 = (1-\gamma_2)k''_1 \quad , \qquad (18a,b)$$

which leads to

$$\gamma_{22} = -\gamma_2 k''_1 /k'_1 \quad , \quad \gamma_{23} = 1 \qquad (19a,b)$$

$$\gamma_{32}= 1 \qquad , \quad \gamma_{33} = \frac{\gamma_2}{1-\gamma_2^2} \cdot \frac{k'_1}{k''_1} \quad , \qquad (19c,d)$$

and on the other,

$$k'_2 = k'_1/(1+\gamma_2) \quad , \quad k''_2 = \gamma_2 k'_2 \quad , \qquad (20a,b)$$

which leads to

$$\gamma_{22} = -\gamma_2 k''_2/k'_1 \qquad , \quad \gamma_{23} = 1 \quad , \qquad (21a,b)$$

$$\gamma_{32} = \frac{1-\gamma_2^2}{\gamma_2} \cdot \frac{k''_1}{k'_1} \quad , \qquad \gamma_{33} = 1 \cdot \qquad (21c,d)$$

These two choices still have to be combined with those available for $N_1$, i.e., for $k'_1$ and $k''_1$ , thus yielding altogether four choices. Due to $|\gamma_2| < 1$, taking into account (10), we can always ensure that none of the coefficients in (16) is larger than unity in modulus, and this independently of which one of the alternatives for $N_1$ has been adopted. The property mentioned is indeed achieved by (19) or (21) if

$$|\gamma_2/(1-\gamma_2^2)| \leq |k''_1/k'_1| \text{ or } |\gamma_2/(1-\gamma_2^2)| \geq |k''_1/k'_1| \quad , \qquad (22)$$

respectively. Note that from (18) and (20b) we also obtain

$$k''_2/k'_2 = (1-\gamma_2^2)k''_1/k'_1 \quad \text{and} \quad k''_2/k'_2 = \gamma_2 \quad , \qquad (23)$$

respectively. These expressions together with (10) show that we have in all cases

$$|k''_2/k'_2| \leq 1 \cdot \qquad (24)$$

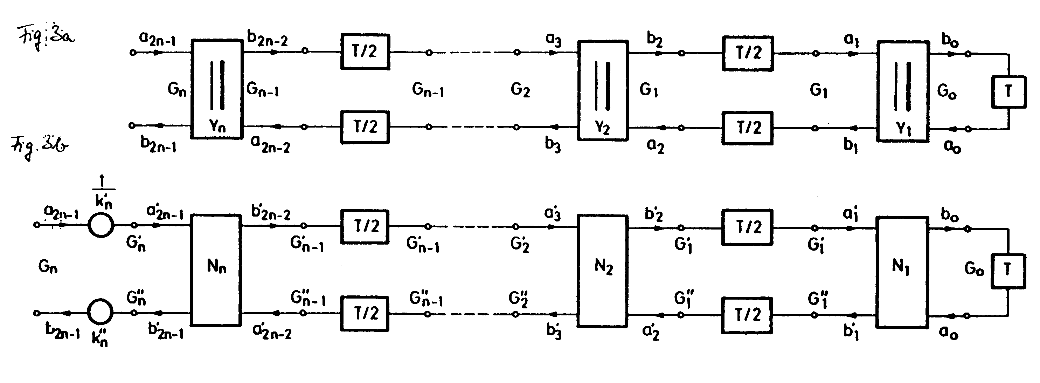

The process described can be obviously extended to all-pass structures of arbitrary degree, say n (Fig. 3a). We then proceed from the right to the left as we have done in Fig. 2, and we thus arrive at a structure of the form given in Fig. 3b. The derivation of $N_3$ will be exactly as that of $N_2$, but with $k'_2$ and $k''_2$ taking the role of $k'_1$ and $k''_1$ etc. The equations describing the i-th two-port parallel adaptor, i = 1 to n, are given by

6

$$b_{2i-2} = -\gamma_i a_{2i-2} + (1+\gamma_i)a_{2i-1} , \qquad (25a)$$

$$b_{2i-1} = (1-\gamma_i)a_{2i-2} + \gamma_i a_{2i-1} , \qquad (25b)$$

where

$$\gamma_i = (G_i - G_{i-1})/(G_i + G_{i-1}) \quad |\gamma_i| < 1 , \qquad (26a,b)$$

the $G_o$ to $G_n$ being the consecutive port conductances. We introduce parameters $k_1'$ to $k_n'$ and $k_1''$ to $k_n''$ as well as new signal quantities $a_o'$ to

$$a_{2n-1}'$$

and $b_o'$ to

$$b_{2n-1}'$$

satisfying, for $i = 1$ to $n$, the equations

$$a_{2i-2} = k_{i-1}'' a_{2i-2}' \quad , \quad b_{2i-2} = k_{i-1}' b_{2i-2}' \quad , \qquad (27a,b)$$

$$a_{2i-1} = k_i' a_{2i-1}' \quad , \qquad b_{2i-1} = k_i'' b_{2i-1}' \quad , \qquad (27c,d)$$

with

$$k_o' = k_o'' = 1 \quad , \quad a_o' = a_o \quad , \quad b_o' = b_o \quad . \qquad (28a,b,c,d)$$

This leads to

$$b_{2i-2}' = Y_{2i-2,2i-2}\, a_{2i-2}' + Y_{2i-2,2i-1}\, a_{2i-1}' \quad , \qquad (29a)$$

$$b_{2i-1}' = Y_{2i-1,2i-2}\, a_{2i-2}' + Y_{2i-1,2i-1}\, a_{2i-1}' \quad , \qquad (29b)$$

where

$$Y_{2i-2,2i-2} = -\gamma_i \frac{k_{i-1}''}{k_{i-1}'} \quad , \quad Y_{2i-2,2i-1} = (1+\gamma_i)\frac{k_i'}{k_{i-1}'} \quad ,(30a,b)$$

$$Y_{2i-1,2i-2} = (1-\gamma_i)\frac{k_{i-1}''}{k_i''} \quad , \quad Y_{2i-1,2i-1} = \gamma_i \frac{k_i'}{k_i''} \quad . \qquad (30c,d)$$

These equations thus describe the 4-pole block $N_i$. For the terminal weights of $N_i$ one finds

$$G_i' = k_i'^2 G_i \quad , \quad G_i'' = k_i''^2 G_i \quad , \qquad (31)$$

at least for those at the left-hand side of $N_i$. At the right-hand side of $N_i$ the terminal weights are the same as the corresponding ones at the left-hand side of $N_{i-1}$. They are thus those given by (31), but with i replaced by i-1. In view of (28a,b) this includes the case i = 1.

By appropriate choice of the $k_i'$ and $k_i''$, we can make sure that, for each i = 1 to n, one of the coefficients in (29a) and one of the coefficients in (29b) becomes equal to unity. Each one of the $N_i$, i = 1 to n, thus requires only two multiply-accumulate steps. The two solutions for which this holds are

$$k_i' = k_{i-1}'/(1+\gamma_i) \quad , \quad k_i'' = (1-\gamma_i)k_{i-1}'') \qquad (32a,b)$$

which leads to

$$\gamma_{2i-2,2i-2} = -\gamma_i k_{i-1}''/k_{i-1}', \quad \gamma_{2i-2,2i-1} = 1 \quad , \qquad (33a,b)$$

$$\gamma_{2i-1,2i-2} = 1 \quad , \quad \gamma_{2i-1,2i-1} = \frac{\gamma_i}{1-\gamma_i^2} \cdot \frac{k_{i-1}'}{k_{i-1}'} \quad , \qquad (33c,d)$$

and

$$k_i' = k_{i-1}'/(1+\gamma_i) \quad , \quad k_i'' = k_{i-1}'\gamma_i/(1+\gamma_i) \quad , \qquad (34a,b)$$

which leads to

$$\gamma_{2i-2,2i-2} = -\gamma_i k_{i-1}''/k_{i-1}', \quad \gamma_{2i-2,2i-1} = 1 \quad , \qquad (35a,b)$$

$$\gamma_{2i-1,2i-2} = \frac{1-\gamma_i^2}{\gamma_i} \cdot \frac{k_{i-1}''}{k_{i-1}'} \quad , \quad \gamma_{2i-1,2i-1} = 1 \quad . \qquad (35c,d)$$

Furthermore, one of the two alternatives thus available for $N_i$ is such that it does not imply any multiplier coefficient larger than 1 in modulus. More precisely, while we have in general $2^n$ possibilities for achieving the goal that none of the $N_1$ to $N_n$ requires more than two multiply-accumulate steps, there is always one solution, and usually also only one, for which none of the final multiplier coefficients is larger than one in modulus. This can be shown to be a consequence, among other things, of the fact that one has always either

$$\frac{k_i''}{k_i'} = (1-\gamma_i^2)\frac{k_{i-1}''}{k_{i-1}'} \quad or \quad \frac{k_i''}{k_i'} = \gamma_i \quad ,$$

8

thus, in view of (26b) and (28a,b),

$$\left| k_i'' / k_i' \right| \leq 1 \qquad \text{for} \quad i = 1 \text{ to } n. \qquad (36)$$

This is also the reason why it is never possible to arrive at a choice such as $\gamma_{2i-2,2i-2} = 1$.

The two multipliers remaining at the left of Fig. 3b can be combined into a single multiplier

$$m = k_n'' / k_n',$$

for which we thus also have $|m| \leq 1$, with the inequality sign usually holding. In some cases this single multiplier may even simply be dropped, in others, it may in turn be combined in some fashion with another multiplier, thus leading also to a further saving.

We conclude this section by listing a few useful relations that can be derived after some more or less tedious calculations. For the solution defined by (32) and (33) we obtain, using (26) and (31),

$$\gamma_{2i-2,2i-2}^2 - \frac{\gamma_{2i-2,2i-2}}{\gamma_{2i-1,2i-1}} = \frac{G_{i-1}''}{G_{i-1}'} \qquad (37)$$

$$\frac{G_i'}{G_{i-1}''} = - \frac{\gamma_{2i-1,2i-1}}{\gamma_{2i-2,2i-2}} \quad , \quad \frac{G_i''}{G_{i-1}'} = - \frac{\gamma_{2i-2,2i-2}}{\gamma_{2i-1,2i-1}} \qquad (38a,b)$$

$$G_i' G_i'' = G_{i-1}' G_{i-1}'' \quad , \quad G_i' = (1 - \gamma_{2i-2,2i-2} \gamma_{2i-1,2i-1}) G_{i-1}'. \qquad (39a,b)$$

Similarly, for the solution defined by (34) and (35) we obtain, using again (26) and (31),

$$\gamma_{2i-2,2i-2}^2 - \gamma_{2i-2,2i-2} \gamma_{2i-1,2i-1} = \frac{G_{i-1}''}{G_{i-1}'} \quad , \qquad (40)$$

$$\frac{G_i'}{G_{i-1}''} = - \frac{1}{\gamma_{2i-2,2i-2} \gamma_{2i-1,2i-2}} \quad , \quad \frac{G_i''}{G_{i-1}'} = - \frac{\gamma_{2i-2,2i-2}}{\gamma_{2i-1,2i-2}} \quad , (41a,b)$$

$$G_i' = G_{i-1}' + G_i'' \quad , \quad G_i' = \left( 1 - \frac{\gamma_{2i-2,2i-2}}{\gamma_{2i-1,2i-2}} \right) G_{i-1}' . \qquad (42,a,b)$$

## 3. Realization of circuits with more than 2 terminals

WDFs in lattice configuration have so far turned out to be the most attractive ones from a practical point of view /2/. A lattice WDF can be built by means of two WDF all-pass structures. For these, the results of Section 2 are immediately applicable. In fact, one can make use of these results in different fashions since any all-pass function can be realized by means either of a chain connection of unit elements or a cascade of individual sections of degree, say, one and two. In the former case, we obtain a WDF realization in the form of Fig. 3a, thus leading to the structure of Fig. 3b. In the latter, we are lead to making use of the results described in relation with Figs. 1 and 2. In all cases, however, there obviously will be, for each complete all-pass structure, only one multiplier that has to be implemented in addition to those inside of building blocks such as $N_1$ to $N_n$ in Figs. 1 to 3, i.e., in addition to those implemented in form of muliply-accumulate operations.

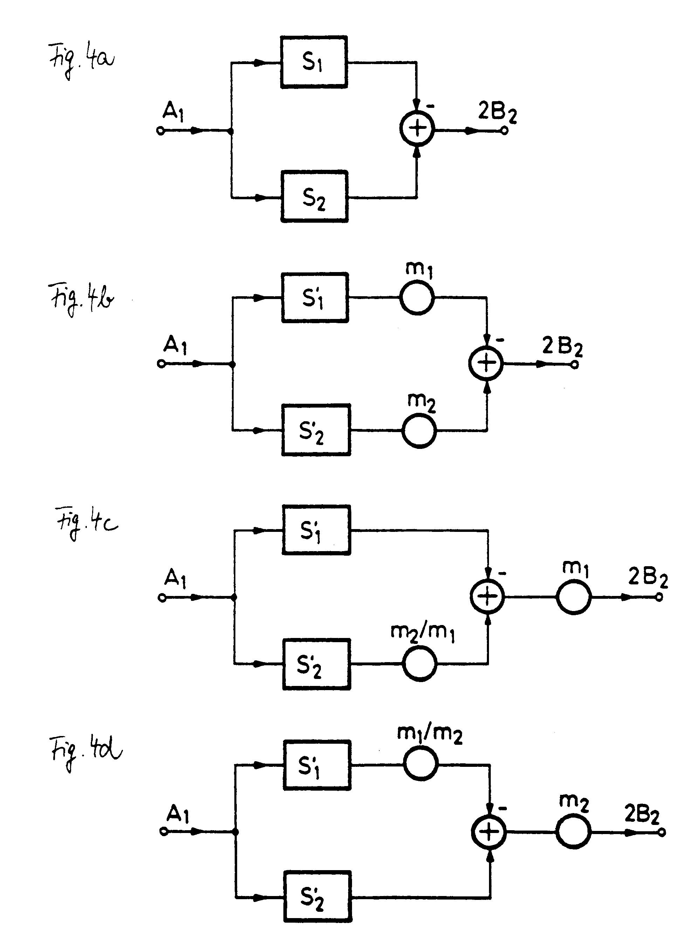

A configuration of a lattice WDF for the case that only one input and one output terminal is used is shown in Fig. 4a. It comprises two branches of all-pass transfer functions $S_1$ and $S_2$, while $A_1$ and $B_2$ are the (steady-state or z-transform) input and output signals, respectively. (The factor 2 at the output is irrelevant; it has been included in order to be in conformity with Fig. 23 in /2/.) Let $S_1'$ and $S_2'$ be those functions corresponding to $S_1$ and $S_2$, respectively, that are obtained by the method explained in Section 2 if we ignore the remaining multipliers mentioned in the previous paragraph.

Clearly, the structure of Fig. 4a is equivalent to that of Fig. 4b where $m_1$ and $m_2$ are the coefficients of the multipliers just referred to. Clearly, the structure of Fig. 4b is equivalent to those of Fig. 4c and 4d. In these, the multipliers $m_1$ and $m_2$, respectively, may again usually be dropped, and the remaining multiplier may be combined with the adder into another multiply-accumulate operation. Note that the discussion given here does not consider scaling requirements.

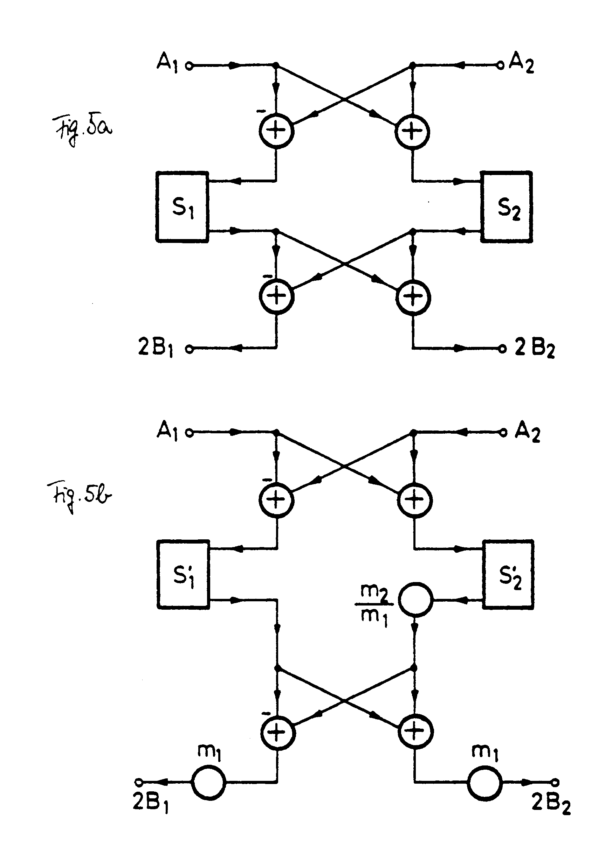

The situation is, obviously, very similar if the full two-port lattice WDF (Fig. 5a) is to be implemented. One of the two main possibilities then available is shown in Fig. 5b.

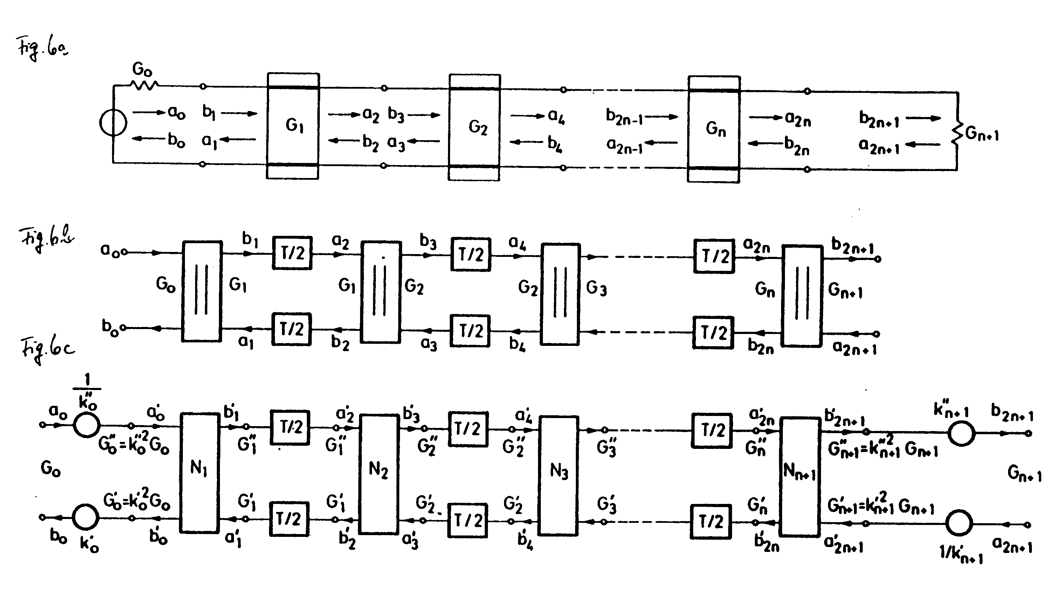

There are also other WDF structures for which the method is directly applicable. This is the case in particular for a WDF (Fig. 6b) obtained from a reference filter in form of a cascade of unit elements (Fig. 6a). We may in this case again start from the end with the port conductance $G_o$, similar to what we have done in Section 2, and then proceed to the other end, which leads us to the structure of Fig. 6c. Note that in Fig. 6 we have adopted a numbering of the $G_i$, $i = 0$ to $n + 1$, which is different from the one we have usually chosen in the case of doubly-terminated filters /2/, but which is more in conformity with the one used in Figs. 1 to 3.

The process is precisely as that described in Section 2, except at the beginning. Indeed, assuming that a multiplier in cascade with an externally accessible terminal is irrelevant, we may introduce multipliers $1/k_o'$ and $k_o''$ in cascade with the input and the output terminal, respectively, of port 0. If we choose

$$k_o' = k_o'' = 1$$

(cf. (28a,b)) everything will be as in Section 2, but if we accept

$$k_o' \neq k_o''$$

we have one additional degree of freedom. This may be used to make one further coefficient (e.g. in $N_1$) equal to unity.

The methods explained in this section may, of course, also be of interest in the case of circuits having more than one input and more than one output terminal.

## 4. Stability considerations

### 4.1 Ideal lossless building blocks

It is known that the most important advantages of WDFs are their excellent stability properties, especially those under the various nonlinear conditions resulting from the unavoidable quantization operations needed for the signal quantities. Due to the way we have derived the new circuits described in Sections 2 and 3, from conventional WDFs it follows that the former must inherit all stability properties of the latter. We will briefly examine the mechanism behind this observation. We do this first under the assumption of ideal lossless building blocks $N_i$. The case of nonideal blocks $N_i$ will be considered in Subsection 4.2.

Consider thus a 4-pole $N_i$, $i \in \{1,2,...,n\}$, of Fig. 3. It is described by the equations (26) to (31), the latter to be used, for a given $N_i$, also with $i$ replaced by i-1. In order to simplify the writing, we consider specifically the case $i = 2$, in which case the equations just mentioned may be replaced by (11), (12), and (14) to (17). (Note that $i = 1$ would not be appropriate if one wants to be general, since for $N_1$ the specific conditions (28) hold.)

The instantaneous power (pseudopower) absorbed by the original adaptor with coefficient $\gamma_2$ is given by

$$p_2 = (G_1 a_2^2 + G_2 a_3^2) - (G_1 b_2^2 + G_2 b_3^2) \tag{43}$$

It is known (and can be verified directly) that, due to losslessness, we have $p_2 = 0$. Using (11), (12), and (15), we obtain from (43),

$$p_2 = (G_1'' a_2'^2 + G_2' a_3'^2) - (G_1' b_2'^2 + G_2'' b_3'^2) . \tag{44}$$

We note that in (44) each one of the four signals $a_2'$, $a_3'$, $b_2'$, and $b_3'$ appears squared and multiplied by the weight of the particular terminal to which the signal refers. Under ideal linear conditions, i.e., if (16) holds, (44) yields again $p_2 = 0$, assuming of course that (11), (12), (14a), and (17) are satisfied.

Mathematically speaking, the main difference between (43) and (44) consists in the fact that while in (43) the second paranthesis comprises the same weights (i.e., $G_1$ and $G_2$) as the first one, this is not the case for (44). It is known however /2,9,10/ that this does not affect any of the stability proofs that have been provided for WDFs. This implies that the same type of quantization rules that guarantee, if applied to the $b_i$, a specific type of stability in the original WDF, will guarantee the same type of stability in the modified WDF if applied to the $b_i'$, with i ranging over an appropriate set of integers.

In order to be more specific, let us designate by $b_{iq}'$ the value resulting from $b_i'$ by quantization. There will be no observable small-scale or large-scale limit cycle if quantization is carried out in such a way that

$$|b_{iq}'| \leq |b_i'|$$

for all relevant values of i. If the circuit is such that it cannot sustain unobservable periodic oscillations under ideal linear conditions and if the rule adopted for overflow corrections is such that a simple sign inversion is excluded, there will be no unobservable limit cycle either. The conditions mentioned allow us also to guarantee stability under looped conditions and to state equally that the limit cycles superposed to the output signal if the input is an arbitrary periodic signal will be very small.

Of particular interest finally is the fact that forced-response stability and related properties /4-8/ can be guaranteed by simply requiring that for all relevant i's the value of $b_{iq}'$ is obtained from the corresponding $b_i'$ by adopting for overflow correction e.g. either simple saturation or a triangular overflow characteristic with slopes of $\pm 45°$. The first of these possibilities is directly available in several digital signal processor (e.g. in the TMS 320 /3/) at the completion of each multiply-accumulate step. Thus, since the computation of any $b_{iq}'$ requires just one such step, using the option available in such a digital signal processor automatically guarantees forced-response stability and related properties.

It should be stressed that all this holds for any type of signal representation, in particular thus not only for fixed-point arithmetic but also for floating-point arithmetic. This is particularly important since any floating-point digital filter that cannot be built strictly without parasitic oscillation can always sustain a parasitic oscillation involving the highest possible value of the exponent /11,12/, in practice thus a parasitic oscillation of high amplitude.

It should finally be recalled that an expression such as that appearing in the right-hand side of (44) corresponds indeed to the definition of the power absorbed in the case of a class of digital filters that appears to be the only one that offers all the same good features as conventional WDFs, yet is in a sense somewhat more general /9/. It had been shown in /9/ that this extended class can always be obtained from conventional WDFs by precisely the type of transformation described in Section 2. Since this type of transformation is of rather trivial nature, the digital filters described in this paper should still appropriately be called "wave digital filters".

In /9/ the question had been left open whether the transformation just referred to can lead to structures offering true advantages over those obtainable by the more conventional WDF approach. The present invention leads to these advantages.

### 4.2 Lossy building blocks

In a conventional WDF an adaptor can be easily made strictly lossless, at least under the assumption that all additions and multiplications are carried out exactly, i.e., that the circuit is strictly linear. This is due to the fact that e.g. for a two-port adaptor described by (13) strict losslessness is fulfilled for any value of $\gamma_2$ provided we adopt port weights $G_1$ and $G_2$ that satisfy (14). Since the latter requirement is trivial to meet, we can, in particular, adopt for $\gamma_2$ any value expressible in a binary representation with finite number of bits. In this case, all four coefficients in (13), in particular thus also the coefficients $(1-\gamma_2)$ and $(1+\gamma_2)$, are expressible in the same way.

This same simple property does not hold for the blocks $N_i$, $i = 1$ to $n$, say, in an all-pass section of the type of Fig. 3b. In order to show this we simply consider $N_1$. Since $G_o' = G_o'' = G_o$ we obtain, for $i = 1$, from (37) and (40)

$$\gamma_{oo}^2 - \frac{\gamma_{oo}}{\gamma_{11}} = 1 \quad \text{and} \quad \gamma_{oo}^2 - \gamma_{oo}\gamma_{1o} = 1 \ , \qquad (45a,b)$$

respectively. Thus $\gamma_{oo}$ and $\gamma_{11}$ (first equation) as well as $\gamma_{oo}$ and $\gamma_{1o}$ (second equation) have to satisfy an expression that usually cannot be fulfilled if these coefficients have to be expressed in a finite number of binary digits.

In order to solve this dilemma we observe that for all stability aspects discussed in Subsection 4.1 to hold it is merely required that the blocks $N_i$ are passive, i.e., such that $p_i \geq 0$, $i = 1$ to $n$, and this for all values of the input signals of $N_i$, $p_i$ being defined as given by (44) (for $i = 2$); strict losslessness, i.e., $p_i = 0$ instead of $p_i \geq 0$, is not needed.

We first consider $N_1$, more specifically the choice leading to (7). Let $\gamma_{ooq}$ and $\gamma_{11q}$ be the quantized values of $\gamma_{oo}$ and $\gamma_{11}$, respectively. We may assume the value of $G_o$ to be given, but $G_1'$ and $G_1''$ may have to be replaced by new values, which we designate by $G_{1q}'$ and $G_{1q}''$, respectively; suitable choices for these still have to determined. Let $P_{1q}$ be the power absorbed by $N_1$ under these new conditions. We have

$$P_{1q} = G_o a_o^2 + G_{1q}' a_1'^2 - G_o b_o^2 - G_{1q}'' b_1'^2 \ . \qquad (46)$$

Using (4) (but with $\gamma_{oo}$ and $\gamma_{11}$ replaced by $\gamma_{ooq}$ and $\gamma_{11q}$, respectively) and $\gamma_{o1} = \gamma_{1o} = 1$, this yields

$$P_{1q} = (G_o - \gamma_{ooq}^2 G_o - G_{1q}'')a_o^2 + (G_{1q}' - G_o - \gamma_{11q}^2 G_{1q}'')a_1'^2$$

$$- 2(\gamma_{ooq}G_o + \gamma_{11q}G_{1q}'')a_o a_1' \ . \qquad (47)$$

Any choice of $\gamma_{ooq}$, $\gamma_{11q}$, $G_{1q}'$, and $G_{1q}''$ for which $p_{1q} \geq 0$ for all $a_o$ and $a_1'$ is acceptable.

We will now show that the problem thus formulated is indeed solvable. For this, let us choose $G_{1q}'$ and $G_{1q}''$ such that

$$G_{1q}' = (1 - \gamma_{ooq}\gamma_{11q})G_o \ , \qquad G_{1q}'' = -\frac{\gamma_{ooq}}{\gamma_{11q}}G_o \ , \qquad (48a,b)$$

these expressions corresponding in a sense to (39b) and (38b), respectively, with $i = 1$. In order to lead to the desired stability results, these expressions must yield positive values of the weights $G_{1q}'$ and $G_{1q}''$. For this, observe that in view of (1b) and (7) we have $\gamma_{oo}\gamma_{11} < 0$, and we may thus assume the quantization to be such that the signs of $\gamma_{oo}$ and $\gamma_{11}$ are not reversed, i.e., in particular, that

$$-\gamma_{ooq}\,\gamma_{11q} \geq 0 \,, \qquad -\gamma_{ooq}/\gamma_{11q} \geq 0 \,. \qquad (49)$$

Substitution of (48) in (47) yields

$$p_{1q} = (1 - \gamma_{ooq}^2 + \frac{\gamma_{ooq}}{\gamma_{11q}})G_o a_o^2 \qquad (50)$$

and thus requires

$$\gamma_{ooq}^2 - (\gamma_{ooq}/\gamma_{11q}) \leq 1 \,, \qquad (51)$$

which, in view of (49), is equivalent to

$$\gamma_{ooq}^2 + |\gamma_{ooq}/\gamma_{11q}| \leq 1 \,. \qquad (52)$$

Comparison with (45a) shows that it is easy to carry out a quantization of $\gamma_{oo}$ and $\gamma_{11}$ such that (51) is fulfilled. All requirements are then met if $G'_{1q}$ and $G''_{1q}$ are chosen according to (48).

Next we consider again $N_1$, but with the choice leading to (9). From (46) we now obtain

$$p_{1q} = (G_o - \gamma_{ooq}^2 G_o - \gamma_{1oq}^2 G''_{1q})a_o^2 + (G'_{1q} - G_o - G''_{1q})a_1'^2$$

$$- 2(\gamma_{ooq}G_o + \gamma_{1oq}G''_{1q})a_o a_1'. \qquad (53)$$

By an approach similar to that used before one finds that $p_{1q} \geq 0$ for all $a_o$ and $a_1'$ if e.g. we quantize $\gamma_{oo}$ and $\gamma_{1o}$ in such a way that

$$\gamma_{ooq}^2 - \gamma_{ooq}\gamma_{1oq} \leq 1 \,, \qquad (54)$$

and if we select $G'_{1q}$ and $G''_{1q}$ such that (cf. (41b) and (42a) for $i = 1$)

$$G''_{1q} = -(\gamma_{ooq}/\gamma_{1oq})G_o. \qquad G'_{1q} = G''_{1q} + G_o \,. \qquad (55a,b)$$

Assume next that the circuit involves also $N_2$. Having performed a quantization of the coefficients of $N_1$ and having thus also chosen $G'_{1q}$ and $G''_{1q}$, we may now approach $N_2$. We assume first that for $N_2$ the choice leading to (19) has been adopted. Let $\gamma_{22q}$ and $\gamma_{33q}$ be the quantized versions of $\gamma_{22}$ and $\gamma_{33}$, respectively, let $G'_{2q}$ and $G''_{2q}$ be corresponding choices for $G'_2$ and $G''_2$, respectively, and let $p_{2q}$ be the value thus replacing $p_2$ given by (44). We have

$$p_{2q} = G''_{1q}a_2'^2 + G'_{2q}a_3'^2 - G'_{1q}b_2'^2 - G''_{2q}b_3'^2 \,. \qquad (56)$$

From this we obtain, using (16) (with $\gamma_{22}$ and $\gamma_{33}$ replaced by $\gamma_{22q}$ and $\gamma_{33q}$, respectively) together with (19b) and (19c),

13

$$p_{2q} = (G_{1q}'' - \gamma_{22q}^2 G_{1q}' - G_{2q}'')a_2'^2 + (G_{2q}' - G_{1q}' - \gamma_{33q}^2 G_{2q}'')a_3'^2$$

$$- 2(\gamma_{22q}G_{1q}' + \gamma_{33q}G_{2q}'')a_2'a_3' \quad , \qquad (57)$$

where $G_{1q}'$ and $G_{1q}''$ may be assumed to be known from quantizing the coefficients of $N_1$. Any choice of $\gamma_{22q}$, $\gamma_{33q}$, $G_{2q}'$, and $G_{2q}''$ for which $p_{2q} \geq 0$ for all $a_2'$ and $a_3'$ is acceptable.

One such choice is obtained if we put

$$G_{2q}' = (1 - \gamma_{22q}\gamma_{33q})G_{1q}' \quad , \qquad G_{2q}'' = -(\gamma_{22q}/\gamma_{33q})G_{1q}' \quad , \qquad (58a,b)$$

these expressions corresponding in a sense to (39b) and (38b), respectively, with $i = 2$. This leads again to positive weights $G_{2q}'$ and $G_{2q}''$; indeed it follows from (14b), (19a), and (19d) that $\gamma_{22}\gamma_{33} < 0$ so that we may assume

$$\gamma_{22q}\gamma_{33q} < 0 , \qquad \gamma_{22q}'\gamma_{33q} < 0. \qquad (59)$$

Inserting (58) into (57) leads to

$$p_{2q} = (G_{1q}'' - \gamma_{22q}^2 G_{1q}' + (\gamma_{22q}/\gamma_{33q})G_{1q}')a_2'^2 \quad , \qquad (60)$$

from which we derive the requirement

$$\gamma_{22q}^2 - (\gamma_{22q}/\gamma_{33q}) \leq G_{1q}''/G_{1q}' \quad . \qquad (61)$$

Hence, a quantization according to (61) together with a choice of $G_{2q}'$ and $G_{2q}''$ according to (58) meets all the requirements.

If for $N_2$ we adopt the choice leading to (21), it turns out that (57) is replaced by

$$p_{2q} = (G_{1q}'' - \gamma_{22q}^2 G_{1q}' - \gamma_{32q}^2 G_{2q}'')a_2'^2 + (G_{2q}' - G_{1q}' G_{2q}'')a_3'^2$$

$$- 2(\gamma_{22q}G_{1q}' + \gamma_{32q}G_{2q}'')a_2'a_3' \quad . \qquad (62)$$

We now have to perform the quantization of $\gamma_{22}$ and $\gamma_{32}$ as well as the choice of $G_{2q}'$ and $G_{2q}''$ in such a way that $p_{2q} \geq 0$ for all $a_2'$ and $a_3'$. A possible simple solution for this can be found in a similar way as before, i.e., by combining the requirement

$$\gamma_{22q}^2 - \gamma_{22q}\gamma_{32q} \leq G_{1q}''/G_{1q}' \qquad (63)$$

with the choice

$$G_{2q}'' = -(\gamma_{22q}/\gamma_{32q})G_{1q}' \qquad G_{2q}' = G_{1q}' + G_{2q}'' \quad . \qquad (64a,b)$$

14

If $n > 2$, the process can be continued until we reach $N_n$. Thus, for any $i \in \{1,2,...,n\}$ and with

$$G'_{i-1,q}$$

and

$$G''_{i-1,q}$$

known, we must quantize the coefficients of $N_i$ in such a way that $P_{iq} \geq 0$ for all choices of

$$a'_{2i-1}$$

and

$$a'_{2i-2},$$

with

$$P_{iq} = G''_{i-1,q}a'^2_{2i-2} + G'_{iq}a'^2_{2i-1} - G'_{i-1,q}b'^2_{2i-2} - G''_{iq}b'^2_{2i-1}.$$

A possible solution for this is immediately obtained as generalization of our results given above. Thus, if for $N_i$ we adopt the choice leading to (33) we may first quantize $\gamma_{2i-2,2i-2}$ and $\gamma_{2i-1,2i-1}$ according to

$$\gamma^2_{2i-2,2i-2,q} - \frac{\gamma_{2i-2,2i-2,q}}{\gamma_{2i-1,2i-1,q}} \leq \frac{G''_{i-1,q}}{G'_{i-1,q}} \qquad (65)$$

and then choose $G'_{iq}$ and $G''_{iq}$ according to

$$G'_{iq} = (1-\gamma_{2i-2,2i-2,q}\gamma_{2i-1,2i-1,q})G'_{i-1,q}, \qquad (66a)$$

$$G''_{iq} = -(\gamma_{2i-2,2i-2,q}/\gamma_{2i-1,2i-1,q})G'_{i-1,q}. \qquad (66b)$$

Similarly, if for $N_i$ we adopt the choice leading to (35) we may quantize $\gamma_{2i-2,2i-2}$ and $\gamma_{2i-1,2i-2}$ according to

$$\gamma^2_{2i-2,2i-2,q} - \gamma_{2i-2,2i-2,q}\gamma_{2i-1,2i-2,q} \leq \frac{G''_{i-1,q}}{G'_{i-1,q}} \qquad (67)$$

15

and then choose $G'_{iq}$ and $G''_{iq}$ according to

$$G''_{iq} = -(\gamma_{2i-2,2i-2,q} / \gamma_{2i-1,2i-2,q}) G'_{i-1,q} \quad , \qquad (68a)$$

$$G'_{iq} = G'_{i-1,q} + G''_{iq} \quad . \qquad (68b)$$

If in such a process an optimum solution (say, with respect to the transmission properties of the circuit) is desired for the quantized coefficients, one should of course repeat the full cycle from 1 to n as often as needed. Note that we could then encounter, for one or more of the $i \in \{1,2,...,n\}$, a case for which one of the two multiplier coefficients may be chosen equal to zero. We then also choose the other coefficient equal to zero and we restrict this situation to the case leading to (33), thus to

$$\gamma_{2i-2,2i-2,q} = \gamma_{2i-1,2i-1,q} = 0$$

and

$$G'_{iq} = G'_{i-1,q} \quad , \qquad G''_{iq} = G''_{i-1,q} \quad .$$

The problem of determing $N_i$ thus then becomes trivial.

After having completed the quantization of the coefficients of the blocks $N_i$, $i = 1$ to n, there may remain the problem of choosing $1/k'_n$ and $k''_n$ (cf. Fig. 3b), or simply that of choosing

$$m = k''_n / k'_n \quad .$$

A need for this does not arise if m may simply be dropped. In other cases such as in Fig. 4c the actual problem is that of finding a quantized value for $m_2/m_1$, where $m_1$ and $m_2$ in turn may be products of factors such as m, but this is not a question of stability.

There may be cases however where passivity from input to output must be guaranteed. In such cases it is best to consider the corresponding transfer function. Let thus

$$A'_{2n-1}$$

and

$$B'_{2n-1}$$

be the steady-state (or z-transform) quantities corresponding to

$$a'_{2n-1}$$

and

$$b'_{2n-1},$$

respectively (Fig. 3b). If all blocks $N_1$ to $N_n$ are designed as discussed above, i.e., if these are all passive, we have /9,10/

$$G'_n |A'_{2n-1}|^2 - G''_n |B'_{2n-1}|^2 \geq 0 \quad,$$

i.e., for the transfer function S,

$$|S|^2 \leq |G'_n/G''_n| \quad \text{where} \quad S = B'_{2n-1}/A'_{2n-1} \quad .$$

Note that in our stability analysis we have specifically examined the case of the structures of Figs. 1 to 3. It is obvious that similar considerations hold for other structures, e.g. for the one of Fig. 6.

In the above procedure of quantizing the multiplier coefficients in such a way that the blocks $N_i$, $i = 1$ to $n$, remain passive, we have, for each case considered, given a specific solution by which the desired goal can be achieved. It should be stressed that other solutions may very well be feasible. Thus, considering the general case of $N_i$, adopting the choice leading to (33), we may replace (66a) by

$$G'_{iq} = -(\gamma_{2i-1,2i-1,q}/\gamma_{2i-2,2i-2,q})G''_{i-1,q} \quad . \tag{69}$$

It can be shown indeed that performing the quantization according to (65) and selecting $G'_{iq}$ and $G''_{iq}$ according to (69) and (66b), respectively, also meets all the requirements.

However, such an alternative cannot be better than the one given by (65) and (66). Indeed, using (65) with i replaced by $i+1$, we see that the quantity

$$K_i = G''_{iq}/G'_{iq}$$

should be as large as possible in order to facilitate as much as possible the quantization of $N_{i+1}$. One verifies that the ratio of the values of $K_i$ obtained by choosing $G'_{iq}$ according to (69) and (66a), respectively, is equal to

$$\left(\gamma^2_{2i-2,2i-2,q} - \frac{\gamma_{2i-2,2i-2,q}}{\gamma_{2i-1,2i-1,q}}\right) \frac{G'_{i-1,q}}{G''_{i-1,q}} \quad,$$

which according to (65) is $\leq 1$.

The situation is similar if for $N_i$ the choice leading to (35) is considered. An alternative solution is then obtained if we replace (68b) by

$$G'_{iq} = -G''_{i-1,q}/(\gamma_{2i-2,2i-2,q}\gamma_{2i-1,2i-2,q}) \quad, \tag{70}$$

but again, it is never better than the one given originally. The reason for this is the same as that given in the previous paragraph.

### 5. WDFs involving adaptors with more than two ports

In certain types of WDFs one has to make use of adaptors with more than two ports. The question thus arises whether the present approach can be extended to such cases.

In principle this question can be answered in the affirmative. It is indeed always possible to introduce pairs of inverse multipliers as we have done in Section 2 and to make use of the freedom thus gained in order to introduce simplifications for the realization of the adaptors. Hence, one can take advantage of this possibility also in the case of adaptors with more than two ports.

In general, however, one cannot expect to arrive at as substantial a gain as in the case of two-port adaptors. The reason for this is that the number of entries of a matrix describing an adaptor increases with the square of the number of ports, while the number of degrees of freedom gained for an adaptor increases only linearly with the number of its ports.

It is thus clear that beyond the two-port adaptors the method appears to be most attractive in the case of three-port adaptors, which are also the ones that are most important in practice. We will not examine this in detail in this paper, but simply point out a few aspects.

We will have to expect that in the case of a three-port adaptor the resulting 6-pole block will be such that 2 multiply-accumulate steps will be necessary for each one of the 3 output signals (except for the output signal at a reflection-free port, which needs only one multiply-accumulate step). A difficulty arises in this case with respect to implementing a simple saturation characteristic, at least if the only possibility of doing it is to apply it after each multiply-accumulate step individually and if the three values to be added do not all have the same sign. A way of avoiding this difficulty is offered if none of the coefficients involved is larger than unity in modulus and if there exists a possibility to arrange the order of the computations in such a way that the first accumulation step concerns two numbers of opposite sign. Even without the latter type of facility, however, overflow stability (as opposed to the more stringent forced-response stability) can be shown to remain guaranteed.

Bibliography

1. A. Fettweis, "Digital filters related to classical filter networks", Arch. Elektr. Übertr., vol. 25, pp. 79-89, Feb. 1979; reprinted in "Selected Papers in Digital Signal Processing II", pp. 510-524, IEEE Press, New York, 1976.
2. A. Fettweis, "Wave digital filters: theory and practice", Proc. IEEE, vol. 74, pp. 270-327, Feb. 1985.
3. S.S. Magar, E. R. Claudel, and A.W. Leigh, "A microcomputer with digital signal processing capability", in Dig. Tech. Papers, IEEE Int. Solid-State Circuits Conf., pp. 32-33, and 284, Feb. 1982.
4. A. N. Willson, Jr., "Some effects of quantization and adder overflow on the forced response of digital filters", Bell. Syst. Tech. J., vol. 51, pp. 863-887, Apr. 1972.
5. T.A.C.M. Claesen, W.F.G. Mecklenbräuker, and J.B.H. Peek, "On the stability of the forced response of digital filters with overflow nonlinearities", IEEE Trans. Circuits Syst., vol. CAS-22, pp. 692 -696, Aug. 1975.
6. K. Meerkötter, "Beiträge zur Theorie der Wellendigitalfilter", Doctoral Dissertation, Ruhr-Universität Bochum, Bochum, W. Germany, Feb. 1979.
7. K. Meerkötter, "Incremental pseudo-passivity of wave digital filters", in Proc. 1st European Signal Processing Conf. (EUSIPCO-80) (Lausanne, Switzerland, Sept. 1980), pp. 27-32.
8. H. Samueli and A.N. Willson, Jr., "Almost period P sequences and the analysis of forced overflow oscillations in digital filters", IEEE Trans. Circuits Syst., vol. CAS-29, pp. 510-515, Aug. 1982.
9. A. Fettweis, "Passivity and losslessness in digital filter structures", Arch. Elektr. Übertr., vol. 44, Jan./Feb. 1988.(in print)
10. A. Fettweis, "Some general properties of signal-flow networks", in Networks and Signal Theory, J.K. Skwirzynski and J.O. Scanlan, Eds., London, England: Peter Peregrinus, 1973, pp. 48-59.
11. T. Kaneko, "Limit cycle oscillations in floating point digital filters", IEEE Trans. Audio Electroacoust., vol. AU-21, pp. 100-106, Apr. 1973.
12. M.I. Youssef, "Realisierung von Wellendigitalfiltern mit Gleitkommaarithmetik", Doctoral Dissertation, Ruhr-Universität Bochum, Bochum, W. Germany, Jan. 1988.

## Claims

1. Wave digital filter comprising at least one m-port adaptor (m≥2) with adders and multipliers, each adaptor comprising at least two interconnecting leads ($a_1$, $b_1$), into each lead a pair of cascaded reciprocal multipliers ($1/K_1'$, $K_1'$; $K_2''$, $1/K_2''$;...) is inserted, and each adaptor being modified by combining the multiplier ($K_1'$, $1/K_1''$, ....) of each pair of reciprocal multipliers with the m-port adaptor to which it is adjacent, characterized in that the modified adaptor is implemented by a general purpose digital signal processor having individual computing cycles for execution of a multiply-add operation consisting respectively of a multiplication combined with an addition.

2. Wave digital filter according to claim 1, characterized in that for cascaded m-port adaptors from which respectively two adjacent adaptors are separated by a delay element (T/2), each adaptor is additionally combined with the other multiplier ($1/k_1'$, $k_1''$, ...) of each inserted pair of reciprocal multipliers which is adjacent to the respective delay element.

3. Wave digital filter according to claim 1 or 2, characterized in that each adaptor is a two-port adaptor (m = 2).

4. Wave digital filter according to claim 1 or 2, characterized in that each adaptor is a three-port adaptor (m = 3).

5. Wave digital filter according to claim 3 or 4, characterized in that for each modified adaptor exactly two multiply-add operations are executed.

6. Wave digital filter according to one of the preceding claims, characterized by a lattice configuration comprising at least one input terminal ($A_1$) and one output terminal ($2B_2$), each of the input terminals ($A_1$) is connected via two different branches to each of the output terminals ($2B_2$), the branches comprising at least one modified adaptor for realizing transfer functions ($S_1'$ and $S_2'$) and comprising remaining multipliers ($m_1$ and $m_2$), which are not implemented in the transfer functions ($S_1'$ and $S_2'$) and from which one remaining multiplier ($m_1$ or $m_2$) in the two branches is inserted into each of the output terminals ($2B_2$).

7. Wave digital filter according to one of the preceding claims, characterized in that the multiply-add operations are executed according to a saturation characteristic.

8. Wave digital filter according to one of the preceding claims, characterized in that the reciprocal multipliers ($1/k_1'$, $k_1'$; $k_2''$, $1/k_2''$; ...) of each inserted pair are quantized in such a way that the modified adaptor remains passive.

**Patentansprüche**

1. Wellendigitalfilter mit mindestens einem jeweils Addierer und Multiplizierer aufweisenden m-Tor-Anpassungsglied (m≥2), das jeweils mindestens zwei Verbindungsleitungen ($a_1$, $b_1$) aufweist, in die jeweils ein Paar von in Kaskade geschalteten zueinander reziproken Multiplizierern ($1/k'_1$, $k'_1$; $k''_2$, $1/k''_2$; ...) eingefügt ist, und das jeweils durch Kombination des zum jeweiligen Paar reziproker Multiplizierer gehörigen Multiplizierers ($k'_1$, $1/k''_1$, ...) mit dem jeweils benachbarten m-Tor-Anpassungsglied modifiziert ist,
**dadurch gekennzeichnet,**
daß das modifizierte Anpassungsglied durch einen digitalen Signalprozessor mit individuellen Berechnungszyklen zur Ausführung einer Multiplizier-Addier-Operation, bestehend jeweils aus einer Multiplikation in Kombination mit einer Addition, realisiert ist.

2. Wellendigitalfilter nach Anspruch 1,
**dadurch gekennzeichnet,**
daß bei in Kaskade geschalteten m-Tor-Anpassungsgliedern, von denen jeweils zwei benachbarte Anpassungsglieder durch ein Verzögerungselement (T/2) getrennt sind, jedes Anpassungsglied zusätzlich mit dem anderen Multiplizierer ($1/k'_1$, $k''_1$,...) jedes eingefügten Paares zueinander reziproger Multiplizierer kombiniert ist, das dem jeweiligen Verzögerungselement benachbart ist.

3. Wellendigitalfilter nach Anspruch 1 oder 2,
**dadurch gekennzeichnet,**
daß jedes Anpassungsglied ein Zweitor-Anpassungsglied (m = 2) ist.

4. Wellendigitalfilter nach Anspruch 1 oder 2,
**dadurch gekennzeichnet,**
daß jedes Anpassungsglied ein Dreitor-Anpassungsglied (m = 3) ist.

**5.** Wellendigitalfilter nach Anspruch 3 oder 4,
**dadurch gekennzeichnet,**
daß für jedes modifizierte Anpassungsglied genau zwei Multiplizier-Addier-Operationen ausgeführt werden.

**6.** Wellendigitalfilter nach einem der vorhergehenden Ansprüche,
**gekennzeichnet durch** eine Brückenanordnung mit mindestens einer Eingangsklemme ($A_1$) und einer Ausgangsklemme ($2B_2$), von denen jede Eingangsklemme ($A_1$) über zwei unterschiedliche Verzweigungen mit jeder Ausgangsklemme ($2B_2$) verbunden ist, wobei in den Verzweigungen mindestens ein modifiziertes Anpassungsglied zur Realisierung von Übertragungsfunktionen ($S'_1$ und $S'_2$) und weitere Multiplizierer ($m_1$ und $m_2$) angeordnet sind, die nicht in den Übertragungsfunktionen ($S'_1$ und $S'_2$) realisiert sind, und von denen ein Multiplizierer ($m_1$ oder $m_2$) in den beiden Verzweigungen an jede Ausgangsklemme ($2B_2$) angefügt ist.

**7.** Wellendigitalfilter nach einem der vorhergehenden Ansprüche,
**dadurch gekennzeichnet,**
daß die Multiplizier-Addier-Operationen nach einer Sättigungskennlinie ausgeführt werden.

**8.** Wellendigitalfilter nach einem der vorhergehenden Ansprüche,
**dadurch gekennzeichnet,**
daß die zueinander reziproken Multiplizierer ($1/k'_1$, $k'_1$; $k''_2$, $1/k''_2$; ...) jedes in die jeweilige Verbindungsleitung ($a_1$, $b_1$) eingefügten Paares so quantisiert sind, daß das modifizierte Anpassungsglied passiv bleibt.

## Revendications

**1.** Filtre numérique travaillant sur des ondes, comprenant au moins un adaptateur à m accès ($m \geq 2$) avec des additionneurs et des multiplieurs, chaque adaptateur comprenant au moins deux conducteurs d'interconnexion ($a_1$, $b_1$), avec une paire de multiplieurs réciproques en cascade ($1/k'_1$, $k'_1$; $k''_2$, $1/k''_2$, ...) insérée dans chaque conducteur, et chaque adaptateur étant modifié en combinant le multiplieur ($k'_1$, $1/k''_1$, ...) de chaque paire de multiplieurs réciproques avec l'adaptateur à m accès auquel il est adjacent, caractérisé en ce que l'adaptateur modifié est réalisé au moyen d'un processeur de signal numérique universel ayant des cycles de calcul individuels pour l'exécution d'une opération de multiplication-addition consistant respectivement en une multiplication combinée avec une addition.

**2.** Filtre numérique travaillant sur des ondes selon la revendication 1, caractérisé en ce que pour des adaptateurs à m accès connectés en cascade, dans lesquels deux adaptateurs adjacents respectifs sont séparés par un élément de retard ($T/2$), chaque adaptateur est en outre combiné avec l'autre multiplieur ($1/k'_1$, $k''_1$, ...) de chaque paire insérée de multiplieurs réciproques qui est adjacent à l'élément de retard respectif.

**3.** Filtre numérique travaillant sur des ondes selon la revendication 1 ou 2, caractérisé en ce que chaque adaptateur est un adaptateur à deux accès ($m = 2$).

**4.** Filtre numérique travaillant sur des ondes selon la revendication 1 ou 2, caractérisé en ce que chaque adaptateur est un adaptateur à trois accès ($m = 3$).

**5.** Filtre numérique travaillant sur des ondes selon la revendication 3 ou 4, caractérisé en ce que pour chaque adaptateur modifié, exactement deux opérations de multiplication-addition sont exécutées.

**6.** Filtre numérique travaillant sur des ondes selon l'une des revendications précédentes, caractérisé par une configuration en treillis comprenant au moins une borne d'entrée ($A_1$) et une borne de sortie ($2B_2$), chacune des bornes d'entrée ($A_1$) étant connectée par l'intermédiaire de deux branches différentes à chacune des bornes de sortie ($2B_2$), les branches comprenant au moins un adaptateur modifié pour réaliser des fonctions de transfert ($S'_1$ et $S'_2$) et comprenant des multiplieurs restants ($m_1$ et $m_2$), qui ne sont pas incorporés dans les fonctions de transfert ($S'_1$ et $S'_2$) et parmi lesquels un multiplieur restant ($m_1$ ou $m_2$) dans les deux branches est inséré dans chacune des bornes de sortie ($2B_2$).

7. Filtre numérique travaillant sur des ondes selon l'une des revendications précédentes, caractérisé en ce que les opérations de multiplication-addition sont exécutées conformément à une caractéristique de saturation.

8. Filtre numérique travaillant sur des ondes selon l'une des revendications précédentes, caractérisé en ce que les multiplieurs réciproques ($1/k_1'$ ,$k_1'$ ; $k_2''$ ,$1/k_2''$ ;...) de chaque paire insérée sont quantifiés d'une manière telle que l'adaptateur modifié reste passif.

EP 0 343 278 B1

Fig. 1a

$$a_1 \quad b_o$$
$$G_1 \quad G_o \quad \boxed{T}$$
$$Y_1$$
$$b_1 \quad a_o$$

Fig. 1b

$$\frac{1}{k_1'}$$
$$a_1 \quad a_1' \quad k_1' \quad a_1 \quad b_o$$
$$G_1' = k_1'^2 G_1$$
$$G_1 \qquad G_1 \quad G_o \quad \boxed{T}$$
$$G_1'' = k_1''^2 G_1$$
$$Y_1$$
$$b_1 \quad b_1' \quad b_1 \quad a_o$$
$$k_1'' \qquad \frac{1}{k_1''} \qquad N_1$$

Fig 1c

$$1/k_1'$$
$$a_1 \quad a_1' \quad b_o$$
$$G_1'$$
$$G_1 \qquad N_1 \qquad G_o \quad \boxed{T}$$
$$G_1''$$
$$b_1 \quad b_1' \quad a_o$$
$$k_1''$$

Fig.2a

Fig.2b

Fig.2c

Fig. 2a

Fig. 2b

Fig. 4a

Fig. 4b

Fig. 4c

Fig. 4d

Fig. 5a

Fig. 5b

EP 0 343 278 B1

Fig.6a

Fig.6b

Fig.6c